(19) Europäisches Patentamt
European Patent Office
Office européen des brevets

(11) Numéro de publication: **0 285 067 B1**

(12) # FASCICULE DE BREVET EUROPEEN

(45) Date de publication de fascicule du brevet: **16.10.91**

(51) Int. Cl.5: **G11C 16/04**, G07B 17/02, G06F 11/08

(21) Numéro de dépôt: **88104984.5**

(22) Date de dépôt: **28.03.88**

(54) **Mémoire non volatile à faible taux d'écriture et machine à affranchir en faisant application.**

(30) Priorité: **31.03.87 FR 8704478**

(43) Date de publication de la demande:
**05.10.88 Bulletin 88/40**

(45) Mention de la délivrance du brevet:
**16.10.91 Bulletin 91/42**

(84) Etats contractants désignés:
**DE FR GB**

(56) Documents cités:
**EP-A- 0 131 343**
**EP-A- 0 172 574**
**DE-A- 3 517 087**
**FR-A- 2 466 834**
**US-A- 4 090 258**

**PATENT ABSTRACTS OF JAPAN, vol. 8, no. 68 (P-264)[1505], 30 mars 1984, page 159 P 264; & JP-A-58 215 794 (TOKYO SHIBAURA DENKI K.K.) 15-12-1983**

(73) Titulaire: **ALCATEL SATMAM**
**113 rue Jean-Marin Naudin**
**F-92220 Bagneux(FR)**

(72) Inventeur: **Vermesse, Bernard**
**2 avenue du Général de Gaulle**
**F-94240 l'Haye les Roses(FR)**

(74) Mandataire: **Weinmiller, Jürgen et al**
**Lennéstrasse 9 Postfach 24**
**W-8133 Feldafing(DE)**

**EP 0 285 067 B1**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

## Description

La présente invention concerne les mémoires non volatiles affectées à l'enregistrement de données successives relatives à une machine à affranchir. Elle porte en particulier sur une mémoire non volatile à faible taux d'écriture affectée à l'enregistrement des données postales d'une machine à affranchir et constituant alors la mémoire du ou des compteurs de la machine à affranchir.
Une mémoire selon le préambule de la revendication 1 est connue de DE-A-35 17 087. Dans une première phase, seules les cellules dans une première zone de la mémoire sont soumises à un cycle de programmation. Après un nombre donné de cycles de programmation relatifs à la première zone, seules les cellules dans une seconde zone sont soumises à un cycle de programmation.

EP-A-0 131 343 décrit une mémoire EEPROM dont les cellules ne sont soumises à un cycle de programmation que si la nouvelle information à inscrire diffère de l'information déjà stockée dans les cellules.

Les machines à affranchir actuellement sur le marché sont, selon le pays, à post-paiement des affranchissements réalisés au cours d'un certain laps de temps ou à pré-paiement des affranchissements qu'elles peuvent réaliser à partir d'un crédit chargé dans la machine.

Dans ces deux types de machine la valeur globale des affranchissements réalisés et, pour les machines à pré-paiement uniquement, le montant de crédit restant utilisable par la machine, constituent les données postales de la machine. Ces données doivent être comptabilisées de manière très sûre et doivent permettre des contrôles possibles pour éviter toute fraude.

Dans les machines à affranchir un compteur ascendant donne, au fur et à mesure des affranchissements, la valeur globale de ces affranchissements. Un compteur descendant donne, au fur et à mesure des affranchissements imprimés, la valeur du crédit restant. Un compteur totalisateur donne la valeur totale des crédits chargés successivement dans la machine, il est associé aux compteurs ascendant et descendant pour permettre un contrôle arithmétique sur les données postales proprement dites.

A chaque chargement de crédit dans la machine, l'état du compteur descendant et l'état du compteur totalisateur augmentent du montant de ce crédit. A chaque affranchissement, la valeur de cet affranchissement est ajoutée au compteur ascendant et retranchée au compteur descendant. Ces deux derniers compteurs évoluent donc à chaque affranchissement.

Le compteur descendant sert également à bloquer la machine en cas d'insuffisance de crédit restant

Les machines à affranchir à post-paiement sont équipées de ces trois compteurs ascendant, descendant et totalisateur. Il n'y a pas de crédit chargé dans la machine ; en conséquence, le compteur descendant cumule également les montants successifs des affranchissements, en valeurs négatives, et le compteur totalisateur reste à zéro.

Dans les systèmes électroniques de comptablisation de données postables d'une machine à affranchir ces compteurs son constitués par un microcalculateur et une mémoire non volatile. Le microcalculateur effectue à chaque affranchissement, ou rechargement, les opérations de mise à jour de la valeur globale des affranchissements réalisés et/ou de la valeur du crédit restant. La mémoire enregistre les nouvelles valeurs de comptage résultantes. Ces valeurs successives sont enregistrées en m bits, m étant comptatible avec la valeur maximale qu'elles peuvent atteindre. Cette mémoire est communément appelée mémoire des compteurs ou même simplement compteurs d'une machine à affranchir.

Pour des raisons de sécurité de fonctionnement, les compteurs ascendant, descendant et totalisateur peuvent être doublés. Les informations contenues dans les compteurs qui se correspondent doivent coïncider, une non concordance entre elles est alors utilisée pour interdire tout affranchissement et bloquer la machine.

Pour les mêmes raisons, le compteur totalisateur est associé au compteur ascendant et au compteur descendant. Ce compteur totalisateur est affecté à l'enregistrement de la valeur globale des crédits qui ont été chargés dans la machine. Il permet un contrôle arithmétique interne du bon fonctionnement de la machine, son contenu devant à tout moment être égal à la somme des contenus des compteurs ascendant et descendant.

Dans les machines électroniques, la ou les mémoires constituant les compteurs doivent répondre en particulier à deux exigences. D'une part elles doivent conserver les informations enregistrées même pendant les mises hors tension ou les défaillances d'alimentation de la machine. D'autre part, elles doivent supporter un nombre de cycles d'écriture au moins égal au nombre de cycles d'affranchissement que peut effectuer la machine ; les cycles de rechargement en crédit qui sont en nombre restant relativement très faible par rapport au cycles d'affranchissements, s'ajoutent à ces derniers puisqu'ils donnent lieu à des nouvelles valeurs des compteurs descendant et totalisateur.

Les mémoires EEPROM (Electrically Erasable Programmable Read Only Memory, en terminologie anglo-saxonne) répondent à cette première exigence. Par contre, elles supportent un nombre de cycles, d'écriture limité qui est insuffisant, en utilisation normale de la mémoire, même pour les machines à affranchir de capacité moyenne les plus courantes sur le marché.

Pour cette dernière raison, les mémoires utilisées sont des mémoires RAM (Random Acces Memory en terminologie anglo-saxonne), qui supportent un nombre infini de cycles d'écriture. Pour répondre à la première exigence, elles sont secourues par une pile, qui fournit l'énergie qui leur est nécessaire lors des mises hors tension ou des défaillances de l'alimentation de la machine.

L'utilisation d'une mémoire RAM secourue par une pile présente une durée de vie limitée du fait même de la pile. Elle nécessite impérativement une surveillance de l'état de la pile et le changement de cette pile au bout d'un certain temps.

L'utilisation d'une pile demande aussi que des composants annexes lui soit associés. Ces composants annexes nuisent à la fiabilité de la machine. En particulier, un défaut de l'un des composants peut entraîner la mise en court-circuit de la pile, avec comme conséquence la perte totale des informations mémorisées. Un choc mécanique ou un accroissement accidentel de température peut provoquer une rupture de l'étanchéité de la pile, par déchirure de son enveloppe étanche, avec pour conséquence sa détérioration et une libération possible d'un certain nombre de produits toxiques, qu'elle contient, dans l'atmosphère environnant.

Le but de la présente invention est de supprimer ces inconvénients.

Elle a donc pour objet une mémoire non volatile à faible taux d'écriture, pour l'enregistrement d'ensembles successifs de données, ayant m bits par ensemble et un nombre R de renouvellements possibles, comportant une mémoire adressable pour un nombre maximal E d'écritures par adresse, ayant un espace mémoire limité, définissant une capacité inférieure à celle requise pour les R renouvellements des dits ensembles de données, affecté auxdits ensembles, caractérisée en ce que ledit espace mémoire limité est organisé en une première zone affectée à l'enregistrement à des premières adresses fixes dans cette première zone de n des m bits de chaque ensemble, qui présentent un nombre de renouvellements inférieur à E, et une deuxième zone affectée à l'enregistrement, à des secondes adresses variables dans cette seconde zone, des m-n bits restants de chaque ensemble, avec au moins l'un des n bits de l'ensemble considéré, dit bit de redondance, et en ce qu'elle comporte, en outre, un circuit programmé de traitement et de gestion d'adressage dudit espace mémoire limité, commandant, à chaque renouvellement desdits n bits, si les bits enregistrés diffèrent des n bits à enregistrer, la désignation desdites premières adresses fixes, pour l'enregistrement des n nouveaux bits se substituant aux précédents, et, à chaque nouvel ensemble, une progression desdites secondes adresses variables, selon une suite en boucle fermée définie par la totalité desdites secondes adresses, pour la désignation de nouvelles secondes adresses d'enregistrement dans ladite deuxième zone desdits m-n bits avec au moins leur bit de redondance.

Selon un mode de réalisation de l'invention, ledit circuit programmé comporte, en outre, des moyens de comptage de ladite progression desdites secondes adresses variables, en nombre de boucles complètes successives, dits compteur d'usure.

Elle a aussi pour objet une machine à affranchir comportant des moyens élaborant les valeurs globales successives des affranchissements réalisés, caractérisée en ce que ledit espace mémoire limité constitue la mémoire dite de compteur ascendant de la machine à affranchir, pour laquelle les valeurs globales successives des affranchissements réalisés sont lesdits ensembles successifs de données et en ce que ledit circuit programmé comporte des moyens de blocage de ladite machine lorsque ledit compteur d'usure atteint le nombre maximal E d'écritures.

Selon un autre mode de réalisation de l'invention, ledit espace mémoire limité constitue, en outre, la mémoire dite de compteur descendant de la machine à affranchir, pour laquelle les valeurs successives de crédit restant associées avec les valeurs successives des affranchissements réalisés forment des couples successifs qui sont lesdits ensembles successifs de données, dont ladite première zone est affectée à l'enregistrement consécutif d'au moins un octet, de poids le plus fort, de chacun des valeurs d'un couple, auxdites premières adresses fixes, et dont ladite deuxième zone est divisée en un nombre entier de compartiments doubles identiques entre eux, pour l'enregistrement consécutifs d'au moins les poids faibles restants des valeurs d'un même couple dans chacun d'eux.

Selon un autre mode de réalisation de l'invention les valeurs successives de crédit restant et les valeurs successives des affranchissements réalisés sont enregistrées chacune associée à un mot de détection d'erreur qui leur est propre.

Selon un autre mode de réalisation, ledit espace mémoire limité est un espace de 256 octets d'une mémoire EEPROM à accès série, dont ladite première zone comporte à des adresses fixes, un compartiment de compteur totalisateur de crédit, un compartiment d'usure de ladite mémoire elle-même, un compartiment double de compteur ascendant et de compteur descendant partiels, pour l'octet de plus fort poids de chacun d'eux, et dont ladite deuxième zone comporte un nombre entier de compartiments doubles identiques de compteur ascendant et de compteur descendant successivement associés au compartiment double de ladite première zone pour contenir les états successifs de ces compteurs.

Les caractéristiques et les avantages de l'invention apparaîtront au cours de la description des exemples de réalisation illustrés dans les dessins ci-annexés. Dans ces dessins.

- La figure 1 est un schéma synoptique illustrant ladite mémoire non volatile selon l'invention ;
- La figure 2 est un schéma montrant une première organisation de l'espace mémoire de la figure 1 ;
- La figure 3 est un schéma montrant une deuxième organisation de l'espace mémoire de la figure 1, pour son application en tant que mémoire des compteurs d'une machine à affranchir ;
- La figure 4 est un organigramme de commande donné en regard de la figure 3 ;
- Les figures 5A, 5B et 5C illustrent un autre organigramme de commande donné en regard de la figure 3.

Dans la figure 1, on a illustré la mémoire non volatile selon l'invention, qui bien que présentant un faible taux d'écriture permet l'enregistrement d'ensembles successifs de données dans un espace mémoire limité affecté à ces ensembles de données.

Cette mémoire non volatile comporte une mémoire EEPROM 1, à nombre maximal E d'écritures par adresse autorisé, dont on a simplement schématisé l'espace mémoire limité affecté à l'enregistrement des ensembles de données, qui est également désigné ci-après par cette référence 1, et un circuit de traitement et de gestion d'adressage 2 de cet espace mémoire limité 1.

Les ensembles successifs de données son relatifs à une machine non illustrée à laquelle la mémoire non volatile est directement couplée. Ils sont transmis à la mémoire non volatile par un bus interne 3. Ils sont à m bits par ensemble et ont un nombre R renouvellements possibles, pour la durée d'utilisation prévue de la machine ; pour cette durée d'utilisation, l'espace mémoire 1 de la mémoire EEPROM est de capacité d'enregistrement insuffisante pour les R fois m bits compte tenu du faible taux d'écriture autorisé, de l'ordre de 10 000 écritures par adresse.

Pour remédier à ce nombre limité d'écritures, l'espace mémoire 1 est divisé ainsi que schématisé dans les figures 2 et 3 en deux zones 5 et 6. La zone 5 est affectée, au moins pour une partie de cette zone, à l'enregistrement à des adresses fixes d'une partie des bits de chaque ensemble de données, soit de n bits parmi les m de chaque ensemble de données, ces n bits présentant pour les R renouvellements des ensembles de données un nombre de renouvellements inférieur au nombre d'écritures E possibles auxdites adresses fixes. La zone 6 est une zone affectée au moins à l'enregistrement, à des adresses variables dans cette zone, des bits restants pour chaque ensemble, soit des m-n bits de l'ensemble considéré, accompagnés d'au moins l'un des bits déjà enregistré dans la zone 5 et dit bit de redondance.

Le circuit 2 de traitement et de gestion d'adressage dudit espace mémoire 1 est un circuit programmé. Il comporte un microcalculateur de traitement 7 couplé au bus 3, auquel sont associés une mémoire RAM 8 d'élaboration de données de commande, fonctionnant notamment en pointeur d'adressage, une mémoire ROM9 de programme, et les circuits d'entrées/sorties 10 d'interface de couplage E/S avec l'espace mémoire 1. Il est piloté par une horloge à quartz non illustrée.

Le schéma de la figure 2, montre l'organisation de l'espace mémoire 1, dans le cas où chaque ensemble de données est la valeur globale des affranchissement réalisés par une machine à affranchir, définie en 33 bits notés Co à C32, (m = 33), qui est à enregistrer sous le contrôle du circuit 2 de traitement et de gestion d'adressage.

Le traitement est effectué en octets. L'octet de poids le plus fort, formé par les bits C32 à C25, de cette valeur de comptage est enregistré dans la zone 5, à des adresses fixes pour cet octet de toutes les valeurs successives possibles. Les 25 bits restants, C24 à Co, accompagnés du bit de poids directement supérieur, C25, déjà affecté à la zone 5, sont enregistrés dans la zone 6.

Avantageusement, à l'enregistrement des 33 bits Co à C32, avec doublement du bit C25 enregistré dans les deux zones 5 et 6 de l'espace mémoire 1, est associé un mot de détection d'erreur directement lié à la valeur de comptage concernée. Le mot de détection d'erreur considéré, défini en 6 bits noté Do à D5, est enregistré, avec les bits Co à C25, dans la zone 6.

Ce mot de détection d'erreur est avantageusement issu de la division de la valeur de comptage considérée par un polynôme irréductible. De préférence, le polynôme utilisé est le polynôme à trois termes, $X^6+X+1$, irréductible et primitif. Il permet de détecter les erreurs sur les compteurs pouvant être exprimés chacun avec un nombre de bits allant jusqu'à 63. Le mot de détection d'erreur est constitué par le reste de cette division, pris sur 6 bits, enregistré avec la valeur de comptage dans l'espace mémoire 1. Un tel mot de détection d'erreur permet ainsi qu'il est connu, de détecter toute erreur provenant d'un retournement d'un bit ou de l'altération d'un groupe de bits. La validité de la valeur de comptage lue dans la mémoire est donnée en effectuant sa division par le polynôme irréductible et en comparant le reste de cette division au mot de détection d'erreur enregistré avec lui.

Bien entendu, le degré de détection d'erreurs est lié à la longueur choisie pour le mot de détection d'erreur associé, dans l'exemple donné cette longueur est de 6 bits.

On a noté en 51 l'emplacement fixe, défini par ses adresses fixes, d'enregistrement dans la zone 5 de l'octet de plus fort poids C32 à C25 de la valeur de comptage. On a noté dans cette même zone 5 en 52, un autre emplacement fixe affecté à l'enregistrement d'informations particulières, avantageusement d'une donnée d'usure de la mémoire volatile, qui sera précisée ci-après et, en 53, un emplacement supplémentaire fixe dit de réserve.

En regard de la zone 6, on a noté en 61 l'emplacement, défini par ses propres adresses, occupé par les bits concernés de la valeur de comptage qui vient d'être enregistrée et ceux de son mot de détection d'erreur. On a noté en 62,---, 69 d'autres emplacements successifs identiques à l'emplacement 61, et chacun défini par leurs propres adresses, qui recevront les bits correspondants des valeurs de comptage successives associées à leur mot de détection d'erreurs.

En regard de cette organisation de l'espace mémoire 1, le circuit programmé de traitement et de gestion d'adressage 2 effectue pour chaque nouvelle valeur de comptage reçue :

- la comparaison de l'octet enregistré à l'emplacement fixe 51 avec le nouvel octet correspondant et, s'ils sont différents, uniquement, l'effacement de l'octet enregistré et l'enregistrement du nouvel octet à ce même emplacement 51,
- l'élaboration du mot de détection d'erreur associé à cette nouvelle valeur de comptage,
- la progression d'un rang de l'emplacement d'enregistrement dans la zone 6, soit de l'emplacement 61 considéré à l'emplacement suivant 62, par progression correspondante de leurs adresses, et le chargement des bits concernés de cette nouvelle valeur de comptage, avec son mot de détection d'erreur, au nouvel emplacement 62 préalablement effacé.

Cette progression des emplacements d'enregistrement des valeurs de comptage successives dans la zone 6, se fait au rytme des valeurs successives reçues, par progression correspondante des adresses d'écriture dans la zone 6 sur la suite continue que définissent les adresses d'un nombre entier de tels emplacements de la zone 6. A cette progression des adresses d'écriture sur toute la suite continue correspond un cycle d'enregistrement dans tous les emplacements de la zone 6. Lorsque le dernier emplacement dans la zone 6 est ainsi atteint ce qui correspond à un cycle d'enregistrement, l'enregistrement de la valeur de comptage suivante se fait dans le premier emplacement de la zone 6 préalablement effacé, ce qui correspond au début d'un nouveau cycle d'enregistrement. Ce passage d'un cycle d'enregistrement à un autre est obtenu en considérant la suite continue des adresses des emplacements de la zone 6 bouclée sur elle même, les adresses progressant alors sur la boucle fermée qu'elles définissent.

La mémoire RAM 8, fonctionnant en registre de comptage bouclé ascendant dit registre d'adresses ou pointeur d'adresse, délivre les adresses des compartiments successifs de la zone 6, sur un cycle d'enregistrement dans cette zone et puis à nouveau l'adresse du premier compartiment de cette zone 6, à la fin de chaque cycle pour un nouveau cycle d'enregistrement. Au passage à zéro, ou à son état minimal de comptage, traduisant l'adresse a16 du premier compartiment de la zone 6, c'est-à-dire pour chaque début de cycle d'enregistrement, un registre dit d'usure associé au registre d'adresse évolue d'un rang. Ce registre d'usure compte les cycles d'enregistrement dans la zone 6.

L'état du registre d'usure définit l'usure de la zone 6, il est enregistré en tant que données d'usure dans la zone 5, dans le compartiment 52 d'adresses fixes. Lorsqu'il atteindra le nombre E, E écritures auront été effectuées par adresse dans la zone 6. La mémoire EEPROM 1 doit être considérée usée. Les données d'usure lorsqu'elles traduisent E cycles d'enregistrement réalisés bloquent la machine à laquelle la mémoire 1 est couplée

Le compartiment 52 est choisie de capacité égale à 2 octets pour enregistrer les données d'usure successives, susceptibles d'évoluer jusqu'à valeur E, E= 10.000.

Un tel espace mémoire 1 géré ainsi que décrit ci-avant constitue la mémoire du compteur d'une machine à affranchir. Cette mémoire est sans entretien, son degré d'usure est mesuré dans le temps ; quand la valeur d'usure atteint E, la machine se bloque et sa mémoire de compteur est à changer.

La figure 3 illustre l'organisation de l'espace mémoire limité 1 de la mémoire non volatile selon la figure 1, pour son utilisation en tant que mémoire des compteurs d'une machine à affranchir. Cette organisation de l'espace mémoire 1 est donnée en regard du type de machines à affranchir couvrant la majorité des besoins du marché, soit une machine à affranchir permettant à l'usager d'effectuer 100 affranchissements par jour, ceci pour 300 jours par an et pendant 10 ans, et présentant une cadence d'affranchissement inférieure à 1000 lettres ou étiquettes par heure.

L'espace mémoire 1 des compteurs ascendant, descendant et totalisateur est choisi de 256 octets, d'adresses respectives par octet notées ao à a255. Chaque valeur de comptage à mémoriser est définie en 33 bits, notés CA32 à CAo, pour le compteur ascendant et notés CD32 à CDo, pour le compteur descendant. Celle du compteur totalisateur est définie en 34 bits, notés CT33 à CTo pour le compteur totalisateur. Chacune de ces valeurs de comptage est enregistrée avec son mot de détection d'erreur, exprimé en 6 bits, notés DAo à DA5, DDo à DD5 ou DTo à DT5, selon le compteur concerné.

Comme dans la figure 2, l'espace mémoire 1 est divisé en deux zones, l'une également désignée par 5 d'enregistrement à adresses fixes et l'autre également désignée par 6 d'enregistrement à adresses variables.

La zone 5 s'étend des adresses ao à a15 comprise. Elle est elle-même divisée en compartiments affectés à l'enregistrement de données de nature différente d'une compartiment à un autre. Ces différents compartiments sont :

- un compartiment de compteur totalisateur 44, de 5 octets, défini aux adresses ao à a4, qui est affecté à l'enregistrement du compteur totalisateur exprimé en 34 bits CT avec son mot de détection d'erreur à 6 bits DTo à DT5,
- un compartiment d'usure 56, de 2 octets, défini aux adresses a5 et a6, qui est affecté à l'enregistrement du nombre de cycles d'enregistrement dans la zone 6, exprimé en 16 bits, notés Uo à U15 pour traduire un nombre de cycles pouvant atteindre le nombre d'écritures E par adresse dans l'espace mémoire 1, E = 10000,
- un compartiment double de compteur descendant partiel et de compteur ascendant partiel 57, de 2 octets, défini aux adresses a7 et a8, qui est affecté à l'enregistrement de l'octet de plus fort poids CD32 à CD25 du compeur descendant et de l'octet de plus fort poids CA32 à CA25 du compteur ascendant,
- un compartiment de réserve 58, de 7 octets, défini aux adresses a9 à a15.

La zone 6 s'étend des adresses a16 à a255. Elle est divisée en 30 compartiments doubles, identiques entre eux, 601 à 630. Chacun de ces 30 compartiments doubles est de 8 octets. Ils son définis l'un après l'autre, respectivement aux adresses a16 à a23, a24 à a31,..., a248 à a255, considérées entre elles selon une suite continue d'adresses. Ces 30 compartiments doubles sont tous affectés à l'enregistrement de données de même nature, qui sont les bits restants CA24 à CAo et CD24 à CDo du compteur ascendant et du compteur descendant, avec pour chaque compteur, son bit de redondance CA25 ou CD25, selon le cas, et son mot de détection d'erreur DAo à DA5 ou DDo à DD5, selon le cas. Ils sont chargés l'un après l'autre, avec effacement préalable du compartiment double alors concerné, au fur et à mesure de l'évolution des compteurs ascendant et descendant selon un cycle d'enregistrement dans toute la zone 6, puis à la fin de ce cycle, selon un nouveau cycle d'enregistrement identique au précédent.

Le circuit de traitement des valeurs de comptage et d'adressage de l'espace mémoire 1 de la figure 3 reste identique à celui illustré dans la figure 1. En pratique, il sera simplement associé au microprocesseur d la machine à affranchir qu'il complètera pour ses fonctions relatives à l'organisation de l'espace mémoire 1.

Les fonctions du circuit de traitement et d'adressage de l'espace mémoire 1 est comparable à celles indiquées ci-avant en regard de l'organisation de l'espace mémoire donnée dans la figure 2, en ce sens que :

- d'une part, il adresse de manière fixe ;
  . le compartiment de compteur totalisateur, 55, à chaque nouvelle valeur de ce compteur, pour l'enregistrement de cette nouvelle valuer en remplacement de la précédente,
  . le compartiment d'usure, 56, à chaque nouvelle valeur des données d'usure élaborée par la mémoire RAM8, pour l'enregistrement de cette nouvelle valeur en remplacement de la précédente,
  . le compartiment de compteur descendant partiel et de compteur ascendant partiel, 57, à chaque nouvelle valeur de l'octet de poids fort de l'un de ces compteurs ou des deux, pour l'enregistrement du nouvel octet de l'un des compteurs avec l'ancien octet de l'autre (lors d'un rechargement de crédit) ou du nouvel octet de chacun de ces deux compteurs (lors de tout affranchissement) selon le cas, en remplacement des précédents,
- d'autre part, il adresse de manière évolutive et selon une boucle fermée, l'un après l'autre les 30 compartiments de la zone 6, à chaque nouvelle valeur de l'un ou de ces deux compteurs, pour l'enregistrement du nouveau couple de bits CA25 à CAo et CD25 à CDo, avec leur mot individuel de détection d'erreur DAo à DA5 et DDo à DD5, dans celui des 30 compartiments alors adressé.

La mémoire EEPROM utilisée est de préférence une mémoire à accès série de la société XICOR, telle que celle du type X24CO4 de capacité de 512 octets organisée en 2 pages chacune de 256 octets. L'une de ces deux pages constitue la mémoire 1 des compteurs ascendant, descendant et totalisateur.

En variante, l'espace de mémoire EEPROM utilisé peut avoir une capacité inférieure à 256 octets, ou supérieure telle que de 512,..., 2048 octets. Le nombre de compartiments dans sa zone d'adressage variable est choisi en fonction d'un nombre prévu d'affranchissements que la machine peut réaliser pendant sa durée d'utilisation. Ainsi une machine à affranchir ayant un espace mémoire de 2048 octets pour les compteurs de la machine, à 254 compartiments dans sa zone d'adressage variable, permet de réaliser 25 400 000 affranchissements.

De manière comparable, des mémoires pouvant supporter un nombre plus important d'écritures, par exemple 20 000 au lieu de 10 000, auront un espace mémoire à deux fois moins de compartiments dans leur zone d'adressage variable, par exemple 15 au lieu des 30 indiqués ci-avant.

Bien entendu, on peut également utiliser une mémoire EEPROM à accès parallèle au lieu des mémoires à accès série ; seul le protocole de transfert de données est différent et non l'organisation de la mémoire elle-même.

La mémoire 1, à accès série, est alors raccordée au circuit 2 de traitement et de gestion d'adressage (figure 1) par 2 fils connectés aux circuits d'entrées/sorties 10. L'un de ces 2 fils véhicule :

- les commandes de lecture ou d'écriture, par octet ou par groupe de 8 octets,
- l'adresse de début de la lecture ou de l'écriture,
- les données à lire ou à écrire.

Cette liaison est bidirectionnelle. La transmission sur ce fil de liaison se fait selon un protocole défini pour ce type de mémoire, à partir du circuit 2.

Le deuxième fil véhicule un signal d'horloge, dans le sens circuit 2 vers la mémoire 1.

Outre les fonctions propres au traitement des valeurs de comptage reçues du microprocesseur de la machine à affranchir et à l'adressage de l'espace mémoire 1, qui sont indiquées ci-avant, le circuit 2 présente des fonctions propres à l'exploitation convenable de la machine à affranchir équipée de cette mémoire des compteurs. Ces dernières fonctions, comme les précédentes, sont définies par la mémoire ROM9 de programme et réalisés par la mémoire RAM8 des données de commande (ou mémoire de travail). Elles concernent essentiellement :

- à chaque mise sous tension de la machine à affranchir, la détection de celui des 30 compartiments doubles 601 à 630 de la zone 6 qui contient la valeur du compteur ascendant et celle du compteur descendant, pour ceux des bits concernés qui sont dans ces compartiments, correspondant au dernier affranchissement réalisé,
- à chaque affranchissement, la reconstitution de la valeur exacte de chacun des compteurs ascendant et descendant à laquelle est à ajouter et à retrancher, selon le compteur, la valeur du timbre qui va ou vient d'être édité.

Ces deux fonctions correspondent à deux programmes spécifiques dans la mémoire ROM9 qui sont définis ci-après et dits programme de mise sous tension et programme de lecture/écriture des compteurs

Le programme de mise sous tension permet de rechercher parmi les 30 compartiments de la zone 6 celui concerné par le dernier affranchissement réalisé.

Le compartiment recherché doit traduitre la valeur maximale du compteur ascendant, ou en variante la valeur minimale du compteur descendant si on exclut que la dernière opération puisse être un rechargement de crédit de la machine à affranchir.

Le déroulement de ce programme de mise sous tension est illustré dans l'organigramme de la figure 4 pour la recherche de l'adresse aP du compartiment double donnant la valeur maximale du compteur ascendant. Ce programme est défini dans la mémoire ROM9 par instructions successives. Pour leur exécution, on dispose dans la mémoire RAM fonctionnant en pointeur d'adresses P de lecture d'octets dans l'espace mémoire, de deux mémoires tampons et d'une mémoire dite de défaut, de 1 bit chacune référencées 12, 14 et 18 respectivement, et de deux mémoires auxiliaires, de 4 octets chacune, référencées 22 et 24, ces mémoires ont été associées à l'organigramme de la figure 4, pour une meilleure compréhension du déroulement de ce programme.

Ces instructions et le déroulement du programme sont précisées ci-après en regard de l'organisation de l'espace mémoire 1 conformément à la figure 3. Dans la figure 4, les phases de décision sont représentées par des losanges ; on a noté sur leurs sorties un o pour traduire non et un 1 pour traduire oui.

Instruction 1 ou instruction d'initialisation :

- mettre le pointeur d'adresse à 8, lire l'octet à l'adresse désignée, prélever le bit CA25 du compteur ascendant et le ranger dans la première mémoire tampon de 1 bit, 12, selon une phase 11 notée P = 8,(12) = CA25
- passer à l'instruction 2.

Instruction 2 :

- ajouter 8 à l'adresse précédemment désignée P, ainsi que schématisée par une phase 13, notée P+8 →P pour désigner la nouvelle adresse courante P,
- comparer la nouvelle adresse courante P à O, selon la phase 15 notée P=O, et
  . si P=O, passer à l'instruction 3,
  . si P est différent de O, lire l'octet à l'adresse P, prélever le bit CA25 de cet octet et le ranger dans la deuxième mémoire tampon de 1 bit, 14, selon une phase 16 notée (14) = CA25,
- comparer les contenus des mémoires 12 et 14, selon une phase 17, notée (12) = (14)
  . s'ils sont différents recommencer l'instruction 2
  . s'ils sont identiques passer à l'instruction 4.

Instruction 3 :

- charger à "1" la mémoire défaut EEPROM 18,
- commander la fin de programme FP, selon une phase 27.

Instruction 4 :

- comparer P à 248, selon une phase 19, notée P = 248, et
  . si P = 248, P est l'adresse du compartiment double contenant la valeur maximale du compteur ascendant donc fin de programme FP,
  . si P est différent de 248 passer à l'instruction 5.

Instruction 5 :

- lire les 4 octets de l'espace mémoire à l'adresse désignée P et les ranger dans la première mémoire auxiliaire de 4 octets, 22, selon une phase 21, notée (22) = CA25,...CAo, DA5,..., DAo, ces bits appartiennent au compteur ascendant.
- ajouter +8 à P, lire les 4 octets à partir de cette nouvelle adresse désignée et les ranger dans la deuxième mémoire auxiliaire de 4 octets, 24, selon une phase 23 notée P+8→P, (24) = CA25,..., CAo, DA5,..., DAo, ces bits appartiennent au compteur ascendant suivant,
- comparer les contenus des mémoires 22 et 24, selon une phase 25, notée (22) ≦ (24), et
  . si (22) ≦ (24) recommencer l'instruction 4,
  . si (22) est supérieur à (24) passer à l'instruction 6.

Instruction 6 :

- retrancher 8 à l'adresse désignée P, selon une phase 26, notée P-8→P, la nouvelle adresse courante désignée P est celle du compartiment double de la zone 6 contenant la valeur maximale du compteur ascendant, dans lequel a été fait l'enregistrement correspondant au dernier affranchissement comptabilisé,
- commander la fin de programme FP.

Au cours du déroulement de ce programme, si CA25 des mémoires 12 et 14 restent différents, l'adresse courante P désignée prend successivement les valeurs 8, 16, 24, 32,..., 248, 0.

La zone 6 a été entièrement balayée sans détection de l'adresse recherchée. Pour P = o la mémoire de défaut EEPROM est mise à "1". elle commande la fin de programme FP.

A la mise sous tension de la machine, la mémoire ROM 9 déclenche également une instruction de lecture du compartiment 56 d'enregistrement d'usure. Un compteur d'usure dans la RAM 8 est forcé à l'ancienne valeur lue dans le compartiment 56.

Lors du fonctionnement de la machine à affranchir, à chaque enregistrement dans le premier compartiment, l'état du compteur d'usure évolue d'une unité qui est à ajouter à l'ancienne valeur enregistrée dans le compartiment 56.

Le compteur d'usure n'est pas matérialisé dans la RAM 8. Il est directement issu du programme de lecture/écriture des compteurs.

Le programme de lecture/écriture des compteurs permet d'élaborer les nouvelles valeurs des compteurs et de les enregistrer dans l'espace mémoire 1, pour chaque affranchissement. Il permet aussi de commander l'évolution des données d'usure U enregistrées en 56.

Le déroulement de ce programme est illustré par les organigrammes des figures 5A, 5B et 5C correspondant à trois sous programmes SP1, SP2 et SP3 exécutés l'un après l'autre. Il est défini dans la mémoire ROM9 et est excécuté par la mémoire RAM fonctionnant également en pointeur d'adresses en désignant l'adresse P de lecture ou d'écriture dans la zone 6, P prenant l'une des valeurs possibles 16, 24,... 240, 248. Pour cette exécution on dispose en outre dans la mémoire RAM8, ainsi que montré associées aux organigrammes des figures 5A à 5C :

- de deux mémoires auxiliaires de compteur ascendant et de compteur descendant, 30 et 40, chacune de 5 octets et formée de 5 registres d'un octet, 31 à35 ou 41 à 45, selon la mémoire considérée,
- une mémoire dite d'affranchissement 70, de 2 octets, mémorisant la valeur de l'affranchissement à comptabiliser,
- de mémoires tampon, de 1 bit, choisies au nombre de quatre pour mieux illustrer leur fonction et référencées 36, 37, 46 et 47, mais pouvant être réduites à deux.

Les instructions successives et le déroulement de ce programme lecture/écriture des compteurs, présenté divisé en sous programmes SP1, SP2 et SP3 successifs, sont précisés ci-après en regard des figures 5A, 5B et 5C et de l'organisation de l'espace mémoire donnée dans la figure 3. Dans ces figures 5A à 5B, les phases de décisions ont également été représentées par des losanges, avec un o de sortie pour traduire non et un 1 de sortie pour traduire oui.

Il est déclenché par tout nouvel affranchissement, donnant lieu à une phase d'intialisation 80.

- SP1 - sous programme de reconstruction de la dernière valeur exacte des compteurs ascendant et descendant dans les registres 30-35 et 40-45 des mémoires auxiliaire de compteur 30 et 40 :

Instruction 1 :

- désigner l'adresse de l'octet des poids forts du compteur descendant, a7, et le charger dans le registre 41 de la mémoire auxiliaire de compteur descendant 40, selon une phase 81 notée a7→(41),
- désigner l'adresse de l'octet des poids forts du compteur ascendant, a8, et le charger dans le registre 31 de la mémoire auxiliaire de compteur ascendant 30, selon une phase 82, notée a8→(31),
- passer à l'instruction 2

Instruction 2 :

- décaler d'un rang vers les poids faible le contenu du registre 31 en forçant à "0" son poids fort et en supprimant CA 25 chargé dans la première mémoire tampon de 1 bit, 36, selon une phase 83, notée O→(31), CA25 = (36),
- décaler d'un rang vers les poids faible le contenu du registre 41 en forçant à "0" son poids fort et en supprimant le bit CD25 chargé dans la deuxième mémoire tampon de 1 bit, 46, selon une phase 84 notée O→(41), CD25 = (46).

A ce stade les contenus des registres 31 et 41 sont :

- (31) : 0 CA32 CA31 CA30 CA29 CA28 CA27 CA26,
- (41) : 0 CD32 CD31 CD30 CD29 CD28 CD27 CD26

Instruction 3 :

- lire les 4 octets à l'adresse courante P désignée par le pointeur pour le dernier enregistrement et les charger dans les registres 32 à 35 de la mémoire auxiliaire de compteur ascendant 30, selon une phase 85 notée P→(32-35),
- lire les 4 octets suivants et les charger dans les registres 42 à 45 de la mémoire auxiliaire de compteur descendant 40, selon une phase 86 notée P+4→(42-45)

A ce stade les contenus des registres des deux mémoires 30 et 40 sont :

| | | |
|---|---|---|
| (31) | : | 0 CA32........................ CA26 |
| (32) | : | CA25........................... CA18 |
| (33) | : | CA17........................... CA10 |
| (34) | : | CA9............................ CA2 |
| (35) | : | CA1 CAO DA5................. DAO |
| | | |
| (41) | : | 0 CD32........................ CD26 |
| (42) | : | CD25........................... CD18 |
| (43) | : | CD17........................... CD10 |
| (44) | : | CD9............................ CD2 |
| (45) | : | CD1 CDO DD5................. DDO |

Instruction 4 :

- décaler d'un rang vers la droite les bits des 5 octets des registres 31-35, avec introduction d'un "0" au poids fort du registre 31, transfert du bit de poids faible d'un registre au poids fort du registre suivant et suppression du bit au poids faible du registre 35 et répéter 5 fois l'opération précédente, selon la phase 87 notée 6. "O"→(30),
- décaler d'un rang vers la droite les bits des 5 octets des registres 41-45, avec introduction d'un "0" au poids fort du registre 41, transfert du bit de poids faible d'un registre au poids fort du registre suivant et suppression du bit de poids faible du registre 45, selon une phase 88 notée 6. "O"→(40).

A ce stade les contenus des deux mémoires auxiliaires de compteur 30 et 40 sont ceux notés dans ces mémoires présentées associées à l'organigramme de la figure 5A.

Ces contenus donnent la valeur exacte du compteur ascendant et du compteur descendant à l'affranchissement précédent.

La fin de cette instruction 4 déclenche le sous-programme SP2.

- SP2- sous-programme d'élaboration de la nouvelle valeur des compteurs ascendant et descendant à enregistrer, selon l'organigramme de la figure 5B, dans laquelle les mémoires 30, 40, 70, 37 et 47 ont été associées.

Instruction 5 :

- ajouter la valeur de l'affranchissement à prendre en compte, qui est enregistrée dans la mémoire d'affranchissement 70, au contenu de la mémoire auxiliaire de compteur ascendant 30 et ranger le résultat dans ses registres 31-35, selon une phase 90 notée (30 + (70).
- retrancher la valeur de l'affranchissement au contenu de la mémoire auxiliaire de compteur descendant 40 et ranger le résultat dans ses registres 41-45, selon une phase 91 notée (40) - (70),
- passer à l'instruction 6 :

Instruction 6 :

- calculer le mot de détection d'erreur associé à chaque nouveau résultat du compteur ascendant et du compteur descendant en divisant ces résultats par un polynome irréductible et primitif $X^6+X+1$ et en prenant le reste exprimé en 6 bits et charger le mot de détection d'erreur dans les poids faibles de la mémoire 30 ou 40, en décalant, avec transfert d'un registre à l'autre, les contenus vers les poids forts, selon une phase 92 notée :

: $X^6$+X+1, DA5...DAO → (30)
DD5...DDO → (40)

- passer à l'instruction 7.

Les contenus sont alors analogues à ceux indiqués en fin de l'instruction 3.

Instruction 7 :

- lire le poids fort du registre 32, CA25, et l'introduire au poids faible du registre 31, en décalant son contenu d'un rang vers la gauche, et dans la mémoire tampon 37, selon une phase 93 notés CA25→-(31), (37),
- lire le poids fort du registre 42, CD25, et l'introduire au poids faible du registre 41, en décalant son contenu d'un rang vers la gauche et dans la mémoire tampon 47, selon une phase 94 notée CD 25→-(41), (47).

Les mémoires 30 et 40 associées dans l'organigramme de cette figure 5B contiennent comme indiqué les nouvelles valeurs à enregistrer dans l'espace mémoire 1 des compteurs compteurs avec leur bit de redondance CA25 ou CD25 et leur mot de détection d'erreur. La fin de l'instruction 7 déclenche le sous-programme d'enregistrement SP3.

- SP3 - sous-programme d'enregistrement dans l'espace mémoire 1.

Instruction 8

- comparer les contenus des mémoires tampons 36 et 37, selon une phase 95 notée (36) = (37), et
  . si les contenus sont identiques passer à l'instruction 9,
  . si les contenus sont différents, désigner l'adresse a8 de l'espace mémoire 1, effacer l'octet désigné et enregistrer à cette adresse le contenu du registre 31, selon la phase 96 notée a8 = (31, et passer à l'instruction 9.

Instruction 9

- comparer les contenus des mémoires tampons 46 et 47, selon une phase 97 notée (46) = (47) et
  . si les contenus sont identiques passer à l'instruction 10 . si les contenus sont différents désigner l'adresse a7 de l'espace mémoire 1, effacer l'octet désigné et enregistrer à cette adresse le contenu du registre 41, selon la phase 98 notée a7 = (41) et passer à l'instruction 10.

Instruction 10 :

- comparer l'adresse P du dernier enregistrement dans la zone 6 à 248, selon une phase 99 notée P = 248 et
  . si P = 248 :
    - faire P = 16, pour le bouclage de la suite des adresses de la zone 6 selon une phase 100 notée P = 16,
    - lire le compartiment d'usure 56 de 2 octets, d'adresses a5 et a6, ajouter + 1 à la donnée d'usure lue U, effacer le compartiment d'usure et enregistrer la nouvelle donnée d'usure, selon une phase 101 notée U+1→U,
    - comparer la valeur U à une valeur maximale selon une phase 102, notée U=E, et bloquer la machine si U=E, selon une phase 110,
  . si P est différent de 248, ajouter 8 à P selon une phase 103 notée P+8→P.
- passer à l'instruction 11.

Instruction 11 :

- effacer les 8 octets successifs désignés par P, enregistrer les contenus des registres 32 à 35 aux emplacements des 4 premiers octets et les contenus des registres 42 à 45 aux emplacements des 4 octets suivants selon la phase notée aP = (32)-(35), aP+4 = (42)-(45).

La fin de cette instruction correspond à la fin du sous-programme SP3 du programme complet de lecture/écriture, selon une phase 105, notée FP.

Les compteurs de la mémoire EEPROM sont alors réalignés.

Lors du déroulement de ce programme, les mémoires tampons 36 et 37 pour les bits CA25 l'un déjà enregistré et l'autre à enregistrer peuvent être remplacées par une seule.

Dans ce cas, au cours de l'instruction 7, le bit CA25 lu dans le registre 32 et celui alors contenu dans la mémoire 36 peuvent être directement comparés pour mettre cette même mémoire 36 à "0" s'ils sont identiques et à "1" s'ils sont différents.

Il peut en être de même pour les mémoires 46 et 47.

Ce sont alors les résultats de ces comparaisons qui sont directement exploités au cours des instructions 8 et 9.

L'utilisation d'un espace limité d'une mémoire EEPROM, géré ainsi que décrit ci-avant, en tant que mémoire des compteurs d'une machine à affranchir présente de nombreux avantages. Outre le fait la mémoire des compteurs est non volatile, on peut citer :

- sa durée d'utilisation, sans maintenance, pendant la durée de vie des machines à affranchir les plus courantes prévues pour 300.000 affranchissements en 10 ans,
- la mesure de cette durée d'utilisation et le blocage de la machine si besoin est,
- l'accroissement des données enregistrées avec la valeur des compteurs ascendant et descendant, permettant d'enregistrer, avec ces deux compteurs, le compteur totalisateur et le mot de détection d'erreur propre à chaque valeur de chaque compteur, pour un contrôle de sécurité,
- l'augmentation possible de la capacité des compteurs de la machine, en particulier d'un octet pour chaque compteur, le compteur totalisateur et les deux octets de plus forts poids du compteur ascendant et descendant sont alors enregistrés dans la zone d'adressage fixe en diminuant de 3 octets le compartiment de réserve.

Une machine à affranchir équipée d'une mémoire des compteurs selon la présente invention présente aussi l'avantage d'être de sécurité encore accrue.

En effet outre le compteur totalisateur et les mots de détection d'erreur enregistrés avec les compteurs ascendant et descendant, la machine peut être équipée de deux mémoires des compteurs, identiques à celle décrite, dont la non concordance de leur contenu bloque à tout moment la machine. De plus, découlant de la présente demande, en cas de défaut consécutif à une panne, la mémoire des compteurs ou les deux mémoires des compteurs, conservent les dernières valeurs enregistrées qui constituent l'historique immédiat de la machine. Cet historique permet de reconstituer l'état juste antérieur à la panne et facilite l'établissement d'un compromis satisfaisant entre l'administration postale et l'usager pour définir l'état sûr des compteurs avant la panne.

Le bit de redondance introduit sur la valeur exacte de chaque compteur, à la jonction entre ceux de poids forts enregistrés en zone d'adressage fixe 5 et ceux de poids faibles enregistrés en zone d'adressage évolutif 6, rend aisée et rapide la détection de la dernière valeur enregistrée. Une telle détection n'est faite que sur les seuls compartiments de la zone 6 ayant le même bit de redondance que le compartiment 51 correspondant de la zone 5.

## Revendications

1. Mémoire non volatile à faible taux d'écriture, pour l'enregistrement d'ensembles successifs de données, ayant m bits par ensemble et un nombre R de renouvellements possibles, comportant une mémoire adressable pour un nombre maximal E d'écritures par adresse, ayant un espace mémoire limité (1), définissant une capacité inférieure à celle requise pour les R renouvellements des dits ensembles de données, affecté auxdits ensembles, caractérisée en ce que ledit espace mémoire limité (1) est organisé en une première zone (5) affectée à l'enregistrement à des premières adresses fixes dans cette première zone de n des m bits de chaque ensemble, qui présentent un nombre de renouvellements inférieur à E, et une deuxième zone (6) affectée à l'enregistrement à des secondes adresses variables dans cette seconde zone des m-n bits restants de chaque ensemble, avec au moins l'un des n bits de l'ensemble considéré, dit bit de redondance, et en ce qu'elle comporte, en outre, un circuit programmé (2) de traitement et de gestion d'adressage dudit espace mémoire limité, commandant, à chaque renouvellement desdits n bits, si les n bits enregistrés diffèrent des n bits à enregistrer la désignation desdites premières adresses fixes, pour l'enregistrement des n nouveaux bits se substituant aux précédents, et, à chaque nouvel ensemble, une progression desdites secondes adresses variables, selon une suite en boucle fermée définie par la totalité desdites secondes adresses, pour la désignation de nouvelles secondes adresses d'enregistrement dans ladite deuxième zone desdits m-n bits avec au moins leur bit de redondance.

2. Mémoire selon la revendication 1, caractérisée en ce que ledit circuit programmé (2) comporte, en outre, des moyens de comptage (101) de ladite progression desdites secondes adresses variables, en nombre de boucles complètes successives, dits compteur d'usure.

3. Mémoire selon la revendication 2, caractérisée en ce qu'elle comporte, dans ladite première zone (5) un premier compartiment (51, 57) d'au moins n bits défini auxdites premières adresses fixes et au moins un second compartiment dit compartiment d'usure (52, 56) défini à des troisièmes adresses fixes dans cette première zone affecté à l'enregistrement dudit compteur d'usure et en ce que ledit circuit programmé (2) commande en outre, à chaque nouvel état du compteur d'usure, la désignation desdites troisièmes adresses fixes pour l'enregistrement de ce nouvel état se substituant au précédent.

4. Machine à affranchir comportant des moyens élaborant les valeurs globales successives des affranchissements réalisés et faisant application d'une mémoire selon l'une des revendications 2 et 3, caractérisée en ce que ledit espace mémoire limité (1) constitue la mémoire dite de compteur ascendant de la machine à affranchir, pour laquelle les valeurs globales successives des affranchissements réalisés sont lesdits ensembles successifs de données et en ce que ledit circuit programmé (2) comporte des moyens de blocage (102) de ladite machine lorsque ledit compteur d'usure atteint le nombre maximal E d'écritures.

5. Machine à affranchir selon la revendication 4, comportant, en outre des moyens élaborant les valeurs successives de crédit restant disponible pour la machine, caractérisée en ce que ledit espace mémoire limité (1) constitue, en outre, la mémoire dite de compteur descendant de la machine à affranchir, pour laquelle les valeurs successives de crédit restant associées avec les valeurs successives des affranchissements réalisés forment des couples (CA, CD) successifs qui sont lesdits ensembles successifs de données, en ce que ladite première zone (5) est affectée à l'enregistrement consécutif d'au moins un octet de poids le plus fort de chacune des valeurs d'un couple, auxdites premières adresses fixes, et en ce que ladite deuxième zone (6) est divisée en un nombre entier de compartiments doubles identiques entre eux, pour l'enregistrement consécutifs d'au moins les poids faibles restants des valeurs d'un même couple dans chacun d'eux.

6. Machine à affranchir selon la revendication 5, caractérisée en ce que ledit circuit programmé (2) comporte, en outre, des moyens (92) pour élaborer un mot dit de détection d'erreur (DA, DD) propre à chacunes des valeurs de chaque couple et qui est associée à la valeur considérée pour son enregistrement avec elle dans ladite deuxième zone (6).

7. Machine à affranchir selon la revendication 6, caractérisée en ce que le mot de détection d'erreur est issu de la division de chacune des valeurs par un polynôme irréductible et primitif $X^6 + X + 1$.

8. Machine à affranchir selon la revendication 7, caractérisée en ce que chacune des valeurs d'un même couple (CA, CD) est enregistrée avec ledit bit de redondance (CA25, CD25) et ledit mot de détection d'erreur (DA, DD) qui lui est propre en un nombre entier d'octets.

9. Machine à affranchir selon l'une des revendications 5 à 8 et comportant en outre des moyens élaborant les valeurs globales successives des crédits alloués successivement à ladite machine, caractérisée en ce que ledit espace mémoire limité (1) comporte, en outre, dans ladite première zone (5) un troisième compartiment (55) défini à des quatrièmes adresses fixes dans cette première zone, affecté à l'enregistrement des valeurs globales successives de crédit (CT) et constituant la mémoire dite de compteur totalisateur de la machine et en ce que ledit circuit programmé (2) commande, en outre, l'adressage dudit troisième compartiment (55) à chaque nouvelle valeur des crédits (CT) pour son enregistrement auxdites quatrièmes adresses fixes en substitution de la précédente.

10. Machine à affranchir selon la revendication 9, caractérisée en ce que ledit espace mémoire limité (1) est de 256 octets et que ladite deuxième zone (6) est divisée en trente compartiment doubles (601-630) chacun de 8 octets.

11. Machine à affranchir selon la revendication 9, caractérisée en ce que, dans ledit espace mémoire limité (1), ladite deuxième zone (6) comporte un nombre de compartiments (601-630) fonction de la capacité dudit espace mémoire et du nombre d'affranchissements à réaliser prévu pour ladite machine, pour le nombre maximal E d'écritures possibles dans ledit espace mémoire.

12. Machine à affranchir selon l'une des revendications 4 à 11, caractérisée en ce que ledit bit de redondance (CA25, CD25) pour chaque ensemble de données est celui situé à la jonction entre les bits enregistrés dans ladite première zone (5) et ladite seconde zone (6).

13. Machine à affranchir selon la revendication 12, caractérisée en ce que ledit circuit programmé (2) comporte des moyens de détection du dernier ensemble enregistré dans ledit espace mémoire limité (1) déclenchés à chaque mise sous tension de ladite machine.

14. Machine à affranchir selon la revendication 13, caractérisée en ce que lesdits moyens de détection de dernier ensemble enregistré comportent :
   - des moyens (11) de lecture et de prélèvement dudit bit de redondance dans ladite première zone (5),
   - des moyens (13, 15) de lecture et de prélèvement dudit bit de redondance dans les compartiments successifs de ladite deuxième zone (6),
   - des moyens de comparaison (17) dudit bit de redondance prélevé dans ladite première zone (5) et de celui prélevé dans chaque compartiment de ladite deuxième zone (6),
   - des moyens de détection (21, 25), parmi ceux des compartiments de la deuxième zone (6) ayant même bit de redondance que celui prélevé de la première zone, du compartiment de la deuxième zone dont le contenu est le plus grand.

15. Machine à affranchir selon l'une des revendications 12 à 14, caractérisée en ce que le circuit programmé (2) comporte des moyens d'élaboration et de chargement d'un nouvel ensemble de données, déclenchés à chaque affranchissement.

16. Machine à affranchir selon la revendication 15, caractérisée en ce que lesdits moyens d'élaboration et de chargement du nouvel ensemble comportent :
   - des moyens (80-88) de reconstruction de la valeur exacte du dernier ensemble de données enregistré dans lesdites première et deuxième zones (5, 6),
   - des moyens d'élaboration dudit nouvel ensemble de données à enregistrer (90, 94),
   - des moyens de comparaison (95, 97) dudit bit de redondance appartenant au dernier ensemble enregistré et de celui appartenant au nouvel ensemble élaboré à enregistrer, commandant ou non, selon le résultat de comparaison, l'adressage de ladite première zone auxdites premières adresses fixes,
   - des moyens (100, 103) d'évolution des adresses variables de ladite seconde zone à partir des adresses du dernier enregistrement dans cette zone, pour l'adressage en écriture de ladite deuxième zone.

17. Machine à affranchir selon la revendication 16, caractérisée en ce que les moyens (100, 103) d'évolution desdites adresses variables sont commandés par des moyens (99) de détection du dernier enregistrement possible sur ladite suite des adresses de ladite deuxième zone qui commandent eux mêmes le compteur d'usure (101).

18. Machine à affranchir selon l'une des revendications 5 à 6, caractérisée en ce que ledit espace limité (1) est un espace d'une mémoire EEPROM à accès série dont ladite première zone (5) comporte, à des adresses fixes, un compartiment de compteur totalisateur de crédit (55), un compartiment de compteur d'usure (56) de la mémoire elle-même, un compartiment double des poids forts de compteur ascendant et de compteur descendant (57), et dont ladite deuxième zone (6) comporte un nombre entier de compartiments doubles identiques pour au moins les poids faibles restants de compteur ascendant et de compteur descendant (601, 630) successivement associés un compartiment double de ladite première zone pour définir lesdits compteurs ascendant et descendant.

## Claims

1. A non-volatile memory which can be inscribed a limited number of times, for recording successive data sets each comprising m bits, and each having the possibility of being renewed R times, the memory comprising a memory device which can be addressed for a maximum number E of times for writing at each address, said memory having a limited memory space (1) attributed to said data sets and defining a capacity which is less than the capacity required for renewing said data sets R times, characterized in that said limited memory space (1) is organized as a first zone (5) for recording n of the m bits in each data set at first fixed addresses in said first zone, said n bits requiring renewing fewer than E times, and a second zone (6) for recording the remaining m-n bits in each data set at second, variable addresses within said second zone, including at least one of the n bits of the set under consideration, referred to as a redundancy bit, and in that it further includes a programmed circuit (2) for processing and handling the addressing of said limited memory space, said circuit controlling, in case of the n bits on record differing from the n bits to be recorded, the designation of said first fixed addresses on each occasion that said n bits are renewed to cause the new n bits to be recorded in the place of the preceding bits, and also causing said second, variable addresses to progress around a closed loop sequence including all of said second addresses on each occasion that a new data set occurs in order to designate the new second addresses in said second zone in which said m-n bits together with at least their redundancy bit are to be recorded.

2. A memory according to claim 1, characterized in that said programmed circuit (2) further includes means (101) for counting the number of complete successive loops through said sequence of said variable second addresses, thereby constituting a wear meter.

3. A memory according to claim 2, characterized in that it comprises in said first zone (5) a first compartment (51, 57) of at least n bits defined in said first fixed addresses, and at least one second wear compartment (52, 56) defined at third fixed addresses in said first zone for recording said wear meter, and in that said programmed circuit (2) also controls the designation of said third fixed addresses each time a new state of the wear meter occurs in order to record said new state instead of the previous state.

4. A franking machine including means that generate successive overall values of the franking operations performed and making use of a memory according to claim 2 or 3, characterized in that said limited memory space (1) constitutes the up meter memory of the franking machine, for which the successive total values of the franking operations performed constitute said successive data sets, and that said programmed circuit (2) includes means (102) for locking said machine when said wear meter reaches the maximum number E of write operations.

5. A franking machine according to claim 4, further comprising means for generating successive values of available credit remaining in the machine, characterized in that said limited memory space (1) also constitutes the down meter memory of the franking machine for which successive values of remaining credit associated with the successive franking values form successive meter value pairs (CA, CD) which constitute said successive data sets, in that said first zone (5) is allocated to consecutive recording of at least one most significant byte of each the values in a pair at said first fixed addresses, and in that said second zone (6) is subdivided into an integer number of mutually identical two-meter compartments for consecutively recording at least the remaining less significant bits of both values in a given pair.

6. A franking machine according to claim 5, characterized in that said programmed circuit (2) further includes means (92) for generating an error detection word (DA, DD) applicable to each of the values of each pair and which is associated with the corresponding value to be recorded together therewith in said second zone (6).

7. A franking machine according to claim 6, characterized in that the error detection word is obtained by dividing each of the values by a primitive irreducible polynominal $X^6 + X + 1$.

8. A franking machine according to claim 7, characterized in that each of the values of a given pair (CA, CD) is recorded together with said redundancy bit (CA25, CD25) and said error detection word (DA, DD) associated therewith as an integer number of bytes of eight bits.

9. A franking machine according to any one of claims 5 to 8 further including means for generating successive total values of successive credit amounts attributed to said machine, characterized in that said limited memory space (1) further includes, in said first zone (5), a third compartment (55) defined at fourth fixed addresses in said first zone for recording successive total credit values (CT) and constituting the cumulative meter memory of the machine, and in that said programmed circuit (2) further controls the addressing of said third compartment (55) for each new credit value (CT) in order to record it at said fourth fixed addresses in place of the preceding value.

10. A franking machine according to claim 9, characterized in that said limited memory space (1) comprises 256 bytes and in that said second zone (6) is divided into 30 two-meter compartments (601-630) each comprising 8 bytes.

11. A franking machine according to claim 9, characterized in that in said limited memory space (1), said second zone (6) comprises such a number of compartments (601-630) which is a function of said memory space and the expected number of franking operations to be performed by said machine, for a given maximum number E of write operations possible in said memory space.

12. A franking machine according to any one of claims 4 to 11, characterized in that said redundancy bit (CA25, CD25) for each data set is situated at the junction between the bits recorded in said first zone (5) and the bits recorded in said second zone (6).

13. A franking machine according to claim 12, characterized in that said programmed circuit (2) includes means for detecting the last data set having been recorded in said limited memory space (1), which means are put into operation each time said machine is switched on.

14. A franking machine according to claim 13, characterized in that said means for detecting the last-recorded data set comprise:
- means (11) for reading and copying said redundancy bit from said first zone (5),
- means (13, 15) for reading and copying said redundancy bit from successive compartments in said second zone (6),
- comparison means (17) for comparing said redundancy bit as copied from said first zone (5) and as copied from each compartment in said second zone (6), and
- detection means (21, 25) for detecting the highest contents second zone compartment from amongst the compartments of the second zone (6) which have the same redundancy bit as the redundancy bit copied from the first zone.

15. A franking machine according to any one of claims 12 to 14, characterized in that the programmed circuit (2) includes means for generating and writing a new data set in response to each franking operation.

16. A franking machine according to claim 15, characterized in that said means for generating and loading a new data set comprise:
- means (80-88) for reconstructing the exact value of the last-recorded data in said first and second zones (5, 6),
- means for generating said new data set to be recorded (90, 94),
- comparator means (95, 97) for comparing said redundancy bit belonging to the last-recorded set with the redundancy bit belonging to the newly generated set to be recorded, with the result of said comparison determining whether addressing is performed or not within said first zone at said first addresses, and
- means (100, 103) for changing the variable addresses of said second zone on the basis of the addresses of the last recording in said zone in order to write address said second zone.

17. A franking machine according to claim 16, characterized in that the means (100, 103) for changing said variable addresses are controlled by means (99) for detecting the last possible recording in said series of addresses in said second zone and for controlling the wear meter (101).

18. A franking machine according to claim 5 or 6, characterized in that said limited space (1) is space in a serial access EEPROM in which said first zone (5) comprises, at fixed addresses: a compartment for a credit cumulating meter (55), a compartment for a wear meter (56) for measuring usage of the memory itself, and a two-meter compartment for the more significant bits of the up meter and the down meter (57), and in which said second zone (6) comprises an integer number of identical two-meter compartments for at least the less significant remaining bits of the up meter and the down meter (601, 630) associated successively with the two-meter compartment of said first zone for defining said up and down meters.

**Patentansprüche**

1. Nicht-flüchtiger Speicher mit kleiner Anzahl möglicher Überschreibungen zur Aufnahme aufeinanderfolgender Datensätze mit m Bits pro Satz und einer Anzahl R möglichen Erneuerungen, wobei der Speicher einen adressierbaren Speicher für eine maximale Anzahl E von Einschreibungen pro Adresse und mit einem begrenzten Speicherraum (1) für diese Sätze aufweist, welcher eine geringere Kapazität als die für die R Erneuerungen der Datensätze erforderliche Kapazität definiert, dadurch gekennzeichnet, daß der begrenzte Speicherraum (1) in zwei Zonen (5, 6) unterteilt ist, von denen die erste (5) der Aufnahme von weniger als E Erneuerungen aufweisenden n der m Bits jedes Satzes an festen ersten Adressen in dieser ersten Zone dient, und die zweite Zone (6) der Aufnahme der m-n übrigen Bits jedes Satzes an veränderlichen zweiten Adressen in dieser zweiten Zone dient, einschließlich mindestens einem der n Bits im jeweiligen Satz, das Redundanzbit genannt wird, und daß der Speicher weiter eine programmierte Verarbeitungs- und Adressenverwaltungsschaltung (2) für den begrenzten Speicherraum aufweist, die bei jeder Erneuerung der n Bits in dem Fall, daß sich die gespeicherten n Bits von den zu speichernden n Bits unterscheiden, den Bestimmungsort der festen ersten Adressen zur Aufnahme der n neuen, die vorherigen Bits ersetzenden Bits steuert, und die bei jedem neuen Satz zur Bezeichnung neuer zweiter Speicheradressen in der zweiten Zone der m-n Bits, unter Einschluß mindestens ihres Redundanzbits, ein Fortschalten deer variablen zweiten Adressen in einer geschlossenen Schleife gemäß einer Abfolge steuert, die durch die Gesamtheit der zweiten Adressen definiert ist.

2. Speicher nach Anspruch 1, dadurch gekennzeichnet, daß die programmierte Schaltung (2) weiter Mittel zum Zählen (101) der Fortschaltung der variablen zweiten Adressen, Abnutzungszähler genannt, aufweist, die die Anzahl der aufeinanderfolgenden vollständigen Schleifen zählen.

3. Speicher nach Anspruch 2, dadurch gekennzeichnet, daß er in der ersten Zone (5) einen ersten Abschnitt (51, 57) mit mindestens n an den festen ersten Adressen definierten Bits und mindestens einen zweiten Abschnitt (52, 56), Abnutzungsabschnitt genannt, aufweist, der an festen dritten Adressen in der ersten, der Speicherung des Abnutzungszählers zugeteilten Zone definiert ist, und daß die programmierte Schaltung (2) weiter bei jedem neuen Stand der Abnutzungszählers den Bestimmungsort der festen dritten Adressen für die Speicherung des neuen Standes steuert, der an die Stelle des vorherigen Standes tritt.

4. Einen Speicher gemäß einem der Ansprüche 2 und 3 anwendende Frankiermaschine mit Mitteln zur Erstellung der aufeinanderfolgenden globalen Werte der durchgeführten Frankierungen, dadurch gekennzeichnet, daß der begrenzte Speicherraum (1) den Aufwärtszählers der Frankiermaschine bildet, für den die aufeinanderfolgenden Werte der durchgeführten Frankierungen die aufeinanderfolgenden Datensätze bilden, und daß die programmierte Schaltung (2) Mittel (102) zum Blockieren der Maschine aufweist, wenn der Abnutzungszähler die maximale Anzahl E an Einschreibungen erreicht.

5. Frankiermaschine nach Anspruch 4, die weiter Mittel zur Erstellung der aufeinanderfolgenden Werte des für die Maschine verfügbaren Restkredits besitzt, dadurch gekennzeichnet, daß der begrenzte Speicherraum (1) weiter den Abwärtszähler der Frankiermaschine bildet, für den die aufeinanderfolgenden Werte des verkleinerten Kredits, die den aufeinanderfolgenden Werten der durchgeführten Frankierungen zugeordnet sind, aufeinanderfolgende Paare (CA, CD) bilden, bei denen es sich um die aufeinanderfolgenden Datensätze handelt, daß die erste Zone (5) für die fortlaufende Speicherung mindestens eines Oktetts mit der höchsten Gewichtung jedes der Werte eines Paares an den festen ersten Adressen eingeteilt ist, und daß die zweite Zone (6) in eine ganzzahlige Anzahl von untereinander identischen Doppelfächern zur fortlaufenden Speicherung mindestens der übrigen niedrigen Gewichtungen der Werte eines gleichen Paars in jedem der Fächer unterteilt ist.

6. Frankiermaschine nach Anspruch 5, dadurch gekennzeichnet, daß die programmierte Schaltung (2) weiter Mittel (92) zur Erstellung eines Wortes (DA, DD), Fehlererfassungswort genannt, aufweist, das für jeden der Werte jedes Paars typisch ist und das dem fraglichen Wert für seine Speicherung zusammen mit dem Wert in der zweiten Zone (6) zugeordnet ist.

7. Frankiermaschine nach Anspruch 6, dadurch gekennzeichnet, daß das Fehlererfassungswort aus der Teilung jedes der Werte durch ein nicht reduzierbares und primitives Polynom $X^6 + X + 1$ hervorgeht.

8. Frankiermaschine nach Anspruch 7, dadurch gekennzeichnet, daß jeder der Werte eines gleichen Paares (CA, CD) mit dem Redundanzbit (CA25, CD25) und dem ihm typischen Fehlererfassungswort (DA, DD) in einer ganzahligen Anzahl von Oktetts gespeichert ist.

**9.** Frankiermaschine nach einem der Ansprüche 5 bis 8, die weiter Mittel zur Erstellung von aufeinanderfolgend globalen Werten der aufeinanderfolgenden, der Maschine zugeteilten Kredite aufweist, dadurch gekennzeichnet, daß der begrenzte freie Speicherraum (1) weiter in der ersten Zone (5) ein drittes Fach (55) aufweist, das an die festen vierten Adressen in der ersten Zone definiert und der Speicherung der aufeinanderfolgenden globalen Kreditwerte (CT) dient und dabei den Summenspeicher der Maschine bildet, und daß die programmierte Schaltung (2) weiter die Adressierung des dritten Fachs bei jedem neuen Kreditwert (CT) für seine Speicherung unter den festen vierten Adressen im Austausch für die vorhergehende Adresse steuert.

**10.** Frankiermaschine nach Anspruch 9, dadurch gekennzeichnet, daß der begrenzte Speicherraum (1) 256 Oktetts umfaßt und daß die zweite Zone (6) in dreißig Doppelfächer (601-630) unterteilt ist, von denen jedes 8 Oktetts umfaßt.

**11.** Frankiermaschine nach Anspruch 9, dadurch gekennzeichnet, daß in dem begrenzten Speicherraum (1) die zweite Zone (6) eine Anzahl von Fächern (601-630) aufweist, die sich in Abhängigkeit von der Kapazität des Speicherraums und der für die Maschine vorgesehenen Anzahl der durchzuführenden Frankierungen ergibt, und zwar unter Berücksichtigung der in der Speicherraum möglichen maximalen Anzahl E von Einschreibungen.

**12.** Frankiermaschine nach einem der Ansprüche 4 bis 11, dadurch gekennzeichnet, daß das Redundanzbit (CA25, CD25) bei jedem Datensatz dasjenige ist, das sich in der Nahtstelle zwischen den gespeicherten Bits der ersten Zone (5) und der zweiten Zone (6) befindet.

**13.** Frankiermaschine nach Anspruch 12, dadurch gekennzeichnet, daß die programmierte Schaltung (2) Mittel zur Erfassung des letzten in dem begrenzten Speicherraum (1) gespeicherten Satzes aufweist, die bei jedem Einschalten der Maschine ausgelöst werden.

**14.** Frankiermaschine nach Anspruch 13, dadurch gekennzeichnet, daß die Erfassungsmittel für den letzten gespeicherten Satz folgende Komponenten aufweisen:

- Mittel (11) zum Lesen und Entnehmen des Redundanzbits in der ersten Zone (5),
- Mittel (13, 15), zum Lesen und Entnehmen des Redundanzbits in den aufeindanerfolgenden Fächern der zweiten Zone (6),
- Mittel (17) zum Vergleichen des in der ersten Zone (5) entnommenen Redundanzbits und des in jedem Fach der zweiten Zone (6) entnommenen Redundanzbits, und
- Mittel (21, 25) zum Erfassen desjenigen Fachs unter den Fächern der zweiten Zone (6), die das gleiche Redundanzbit wie das der ersten Zone entnommene Redundanzbit aufweisen, dessen Inhalt der größte ist.

**15.** Frankiermaschine nach einem der Ansprüche 12 bis 14, dadurch gekennzeichnet, daß die programmierte Schaltung (2) Mittel zum Erstellen und Laden eines neuen Datensatzes aufweisen. die bei jeder Frankierung ausgelöst werden.

**16.** Frankiermaschine nach Anspruch 15, dadurch gekennzeichnet, daß die Mittel zum Erstellen und Laden des neuen Datensatzes folgende Komponenten aufweisen:

- Mittel (80-88) zur Wiederherstellung des exakten Werts des letzten Datensatzes, der in der ersten und in der zweiten Zone (5, 6) gespeichert wurde,
- Mittel zur Erstellung des neuen zu speichernden Datensatzes (90, 94),
- Mittel (95, 97) zum Vergleichen des zum letzten gespeicherten Datensatz gehörenden Redundanzbits mit dem zum neu erstellten und zu registrierenden Satz gehörenden Redundanzbit, wobei die Mittel entsprechend dem Ergebnis des Vergleichs die Adressierung der ersten Zone an den ersten festen Adressen steuern oder nicht, und
- Mittel (100, 103) zur Weiterentwicklung der variablen Adressen der zweiten Zone aufgrund der Adressen des letzten Speichervorgangs in dieser Zone, und zwar zum Adressieren der Einschreibung in die zweite Zone.

**17.** Frankiermaschine nach Anspruch 16, dadurch gekennzeichnet, daß die Mittel (100, 103) zur Weiterentwicklung der variablen Adressen von Mitteln (99) zur Erfassung der letzten möglichen Speicherung in der Adressenfolge der zweiten Zone gesteuert werden, die ihrerseits den Abnutzungszähler (101) steuern.

**18.** Frankiermaschine nach einem der Ansprüche 5 oder 6, dadurch gekennzeichnet, daß der begrenzte Speicherraum (1) ein Bereich eines EEPROM-Speichers mit seriellem Zugriff ist, dessen erste Zone (5) an festen Adressen ein Fach für den Kreditsummenspeicher (55), ein Fach für den globalen Kreditzähler (55) ein Fach für den Abnutzungszähler (56) des Speichers selber und ein Doppelfach für die starken Gewichtungen des Aufwärtszählers und des Abwärtszählers (57) aufweist, wobei die zweite Zone (6) eine ganzzahlige Anzahl von identischen Doppelfächern für mindestens die übrigen geringen Gewichtungen des Aufwärtszählers und des Abwärtszählers (601, 630) aufweist, die nacheinander mit dem Doppelfach der ersten Zone zur Definition des Aufwärtszählers und des Abwärtszählers verbunden sind.

FIG.1

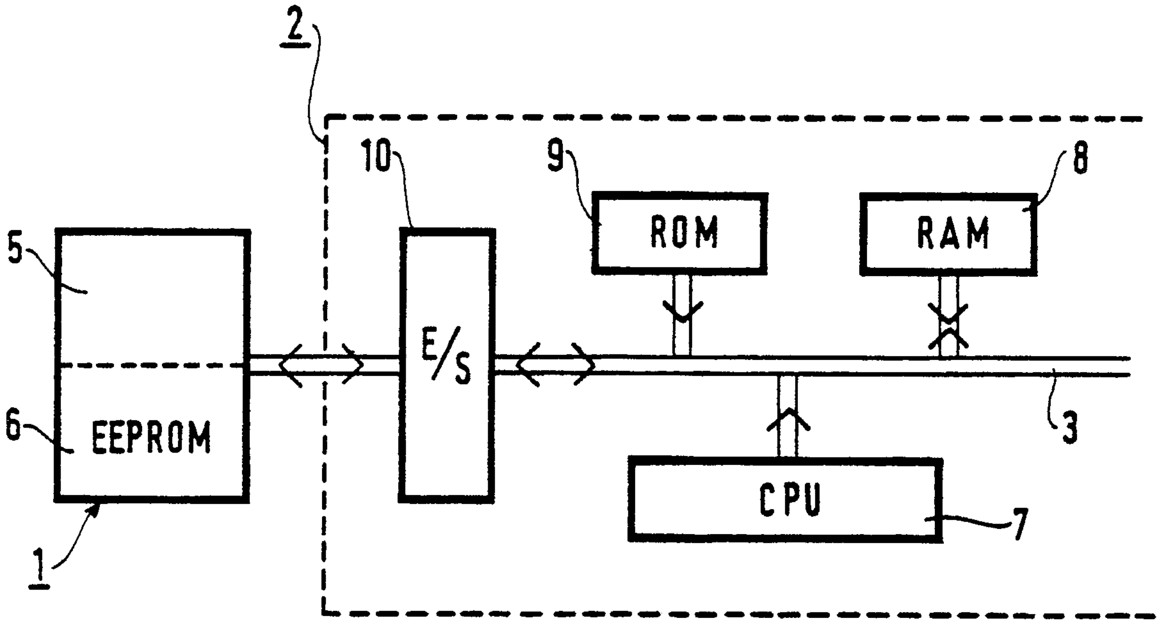
2
10
9
8
ROM
RAM
5
E/S
EEPROM
6
3
CPU
7
1

FIG.2

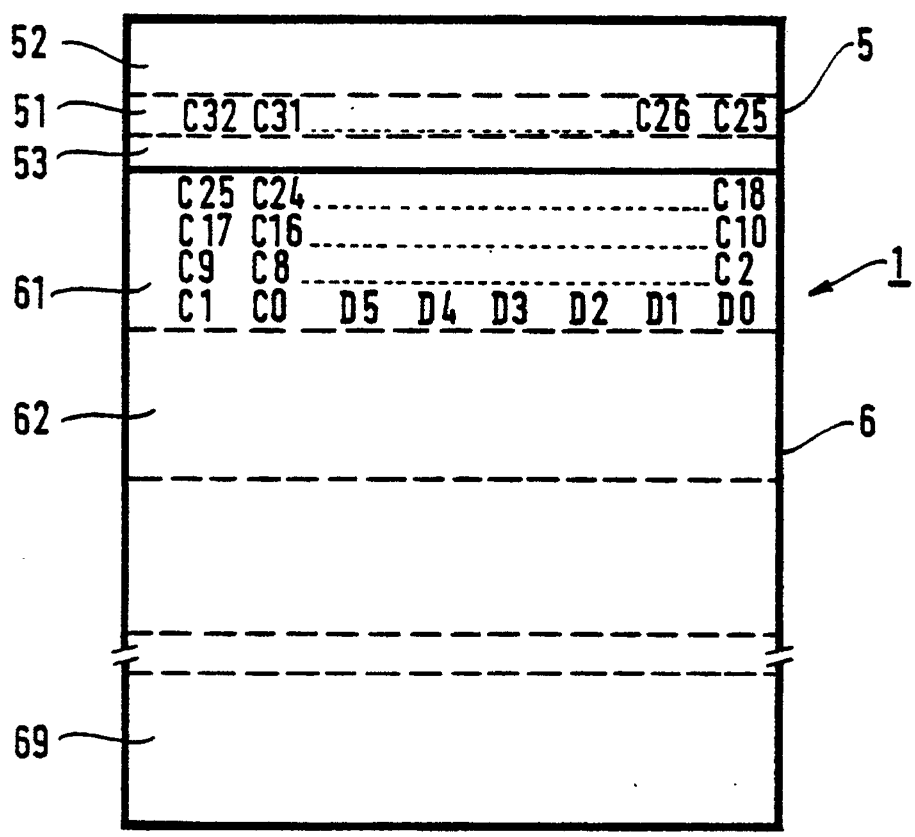
52
51
53
C32 C31
C26 C25
5
C25 C24
C18
C17 C16
C10
C9 C8
C2
61
C1 C0 D5 D4 D3 D2 D1 D0
1
62
6
69

FIG.3

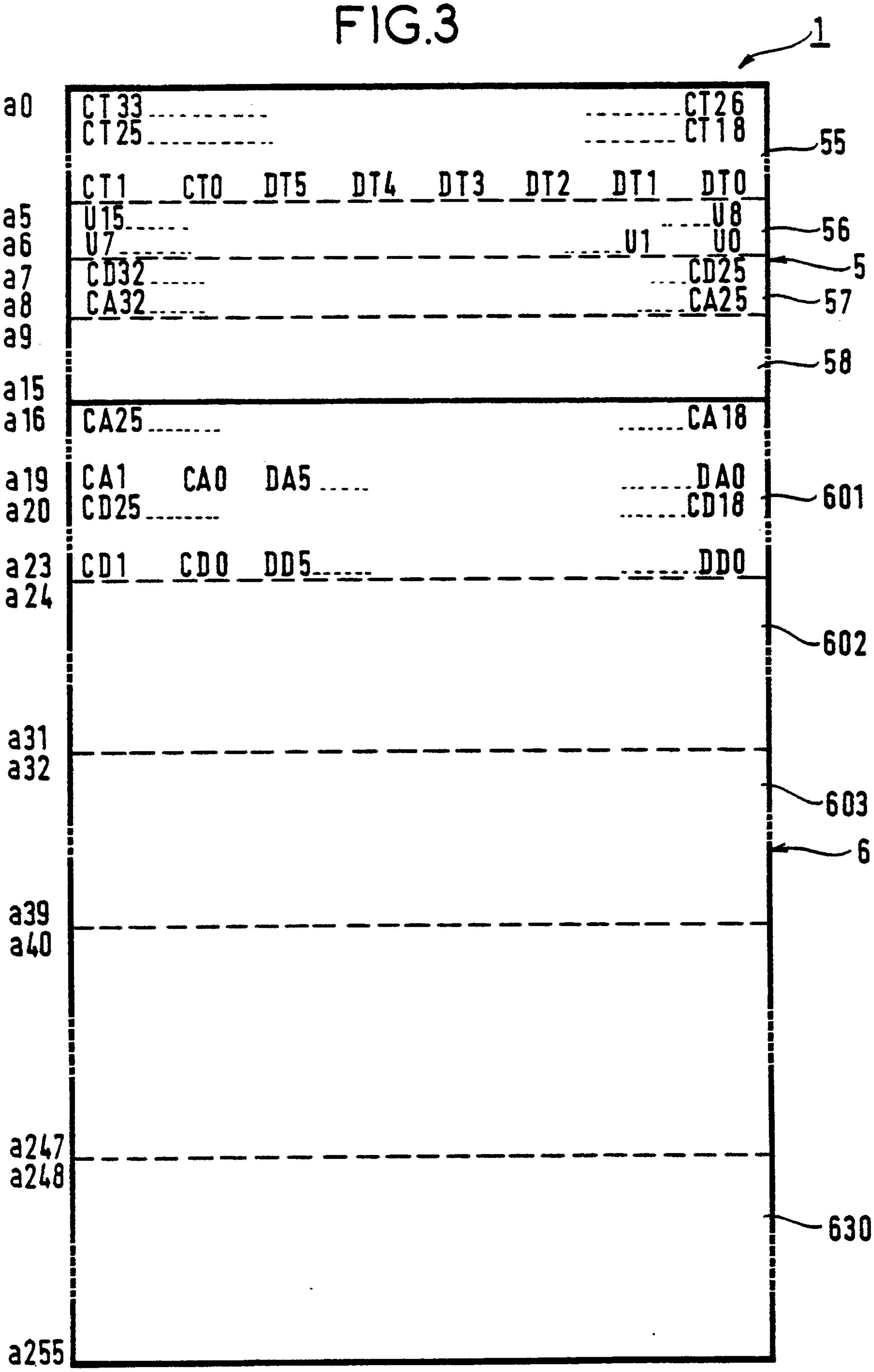
1
a0
CT33
CT26
CT25
CT18
55
CT1
CT0
DT5
DT4
DT3
DT2
DT1
DT0
a5
U15
U8
56
a6
U7
U1
U0
5
a7
CD32
CD25
a8
CA32
CA25
57
a9
58
a15
a16
CA25
CA18
a19
CA1
CA0
DA5
DA0
a20
CD25
CD18
601
a23
CD1
CD0
DD5
DD0
a24
602
a31
a32
603
6
a39
a40
a247
a248
630
a255

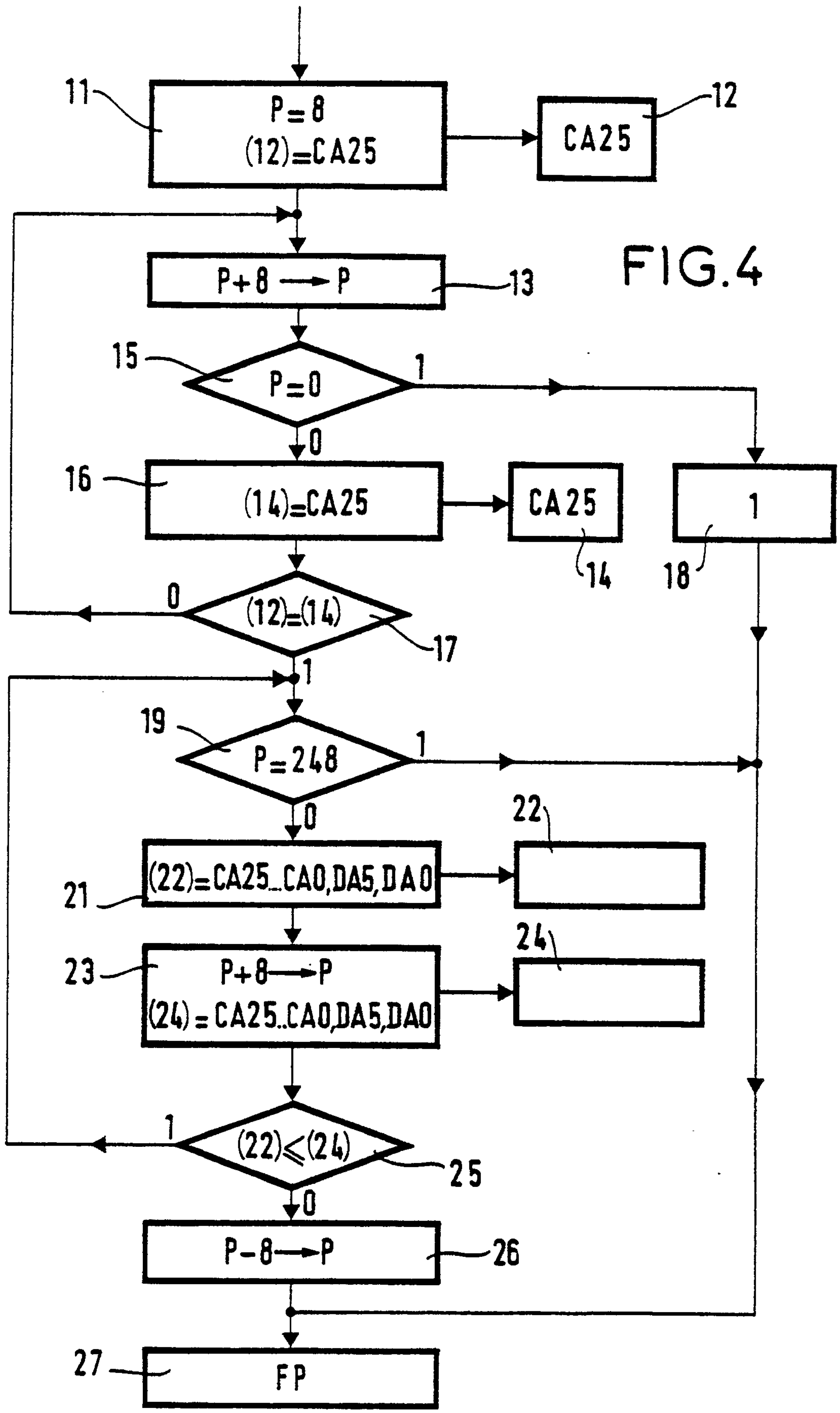
P=8
(12)=CA25
CA25
11
12
P+8 → P
13
15
P=0
1
0
16
(14)=CA25
CA25
1
14
18
0
(12)=(14)
17
1
19
P=248
1
0
22
(22)=CA25...CA0,DA5,DA0
21
24
23
P+8 → P
(24) = CA25..CA0,DA5,DA0
1
(22)⩽(24)
25
0
P−8 → P
26
27
FP

FIG.4

FIG.5A

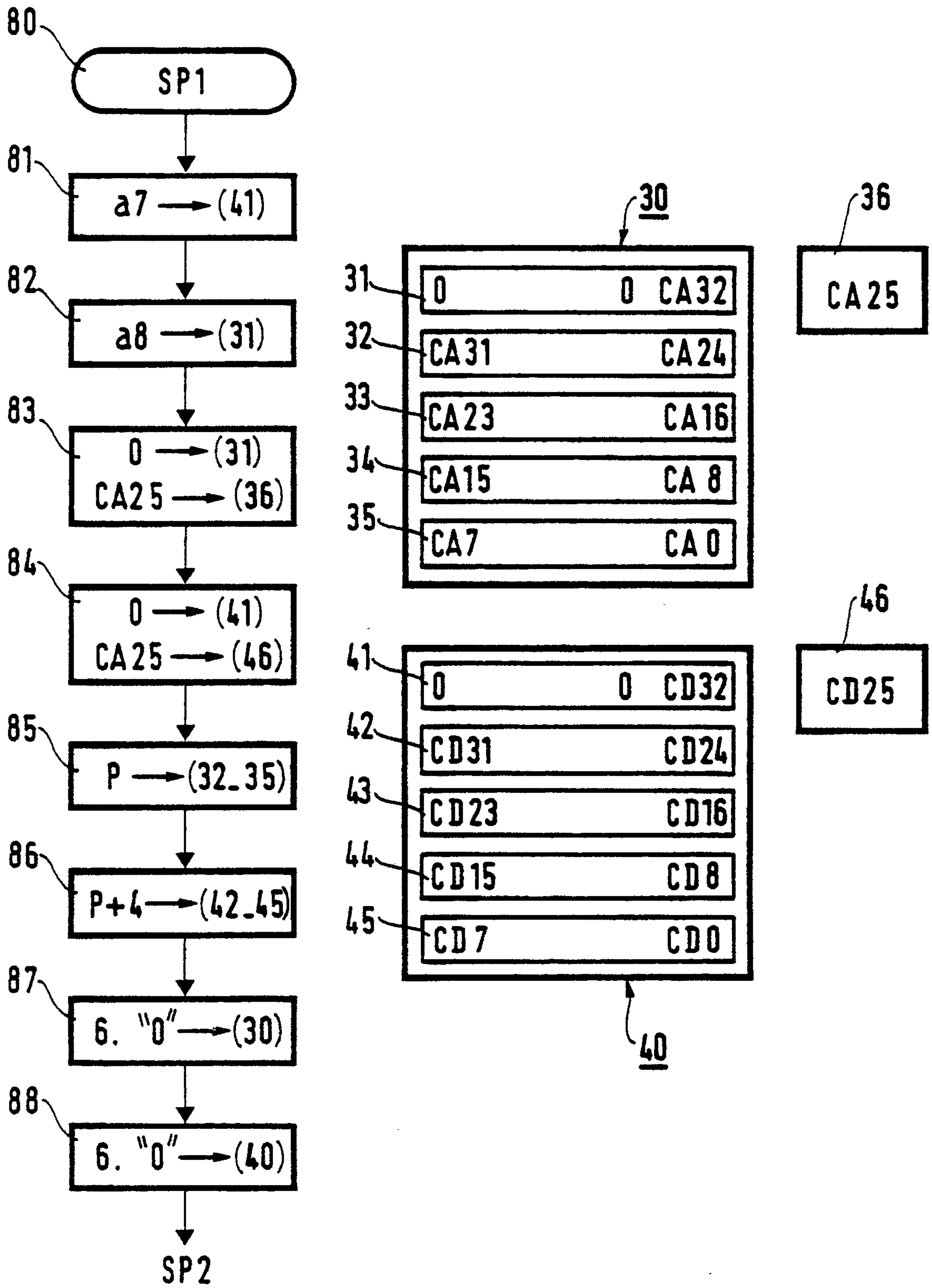
80
SP1
81
a7 → (41)
82
a8 → (31)
83
0 → (31)
CA25 → (36)
84
0 → (41)
CA25 → (46)
85
P → (32_35)
86
P+4 → (42_45)
87
6. "0" → (30)
88
6. "0" → (40)
SP2
30
31
0 0 CA32
32
CA31 CA24
33
CA23 CA16
34
CA15 CA 8
35
CA7 CA 0
36
CA25
46
CD25
41
0 0 CD32
42
CD31 CD24
43
CD23 CD16
44
CD15 CD8
45
CD7 CD0
40

FIG.5B

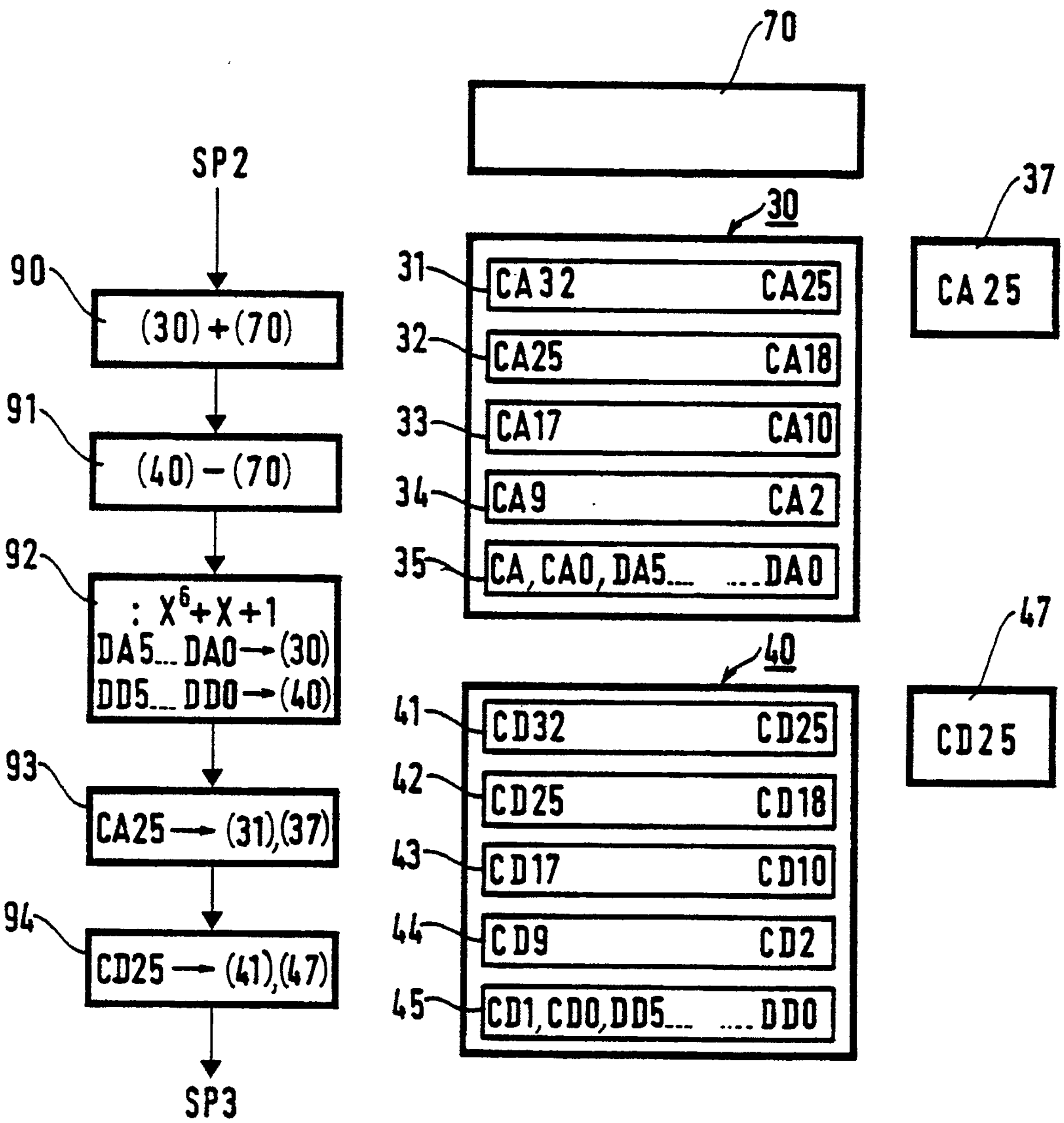
70
SP2
30
37
90
(30)+(70)
31
CA32 CA25
CA 25
32
CA25 CA18
91
33
CA17 CA10
(40)−(70)
34
CA9 CA2
92
35
CA, CA0, DA5.... ....DA0
: X^6+X+1
DA5... DA0→(30)
DD5... DD0→(40)
47
40
41
CD32 CD25
CD25
93
42
CD25 CD18
CA25→(31),(37)
43
CD17 CD10
94
44
CD9 CD2
CD25→(41),(47)
45
CD1, CD0, DD5.... ....DD0
SP3

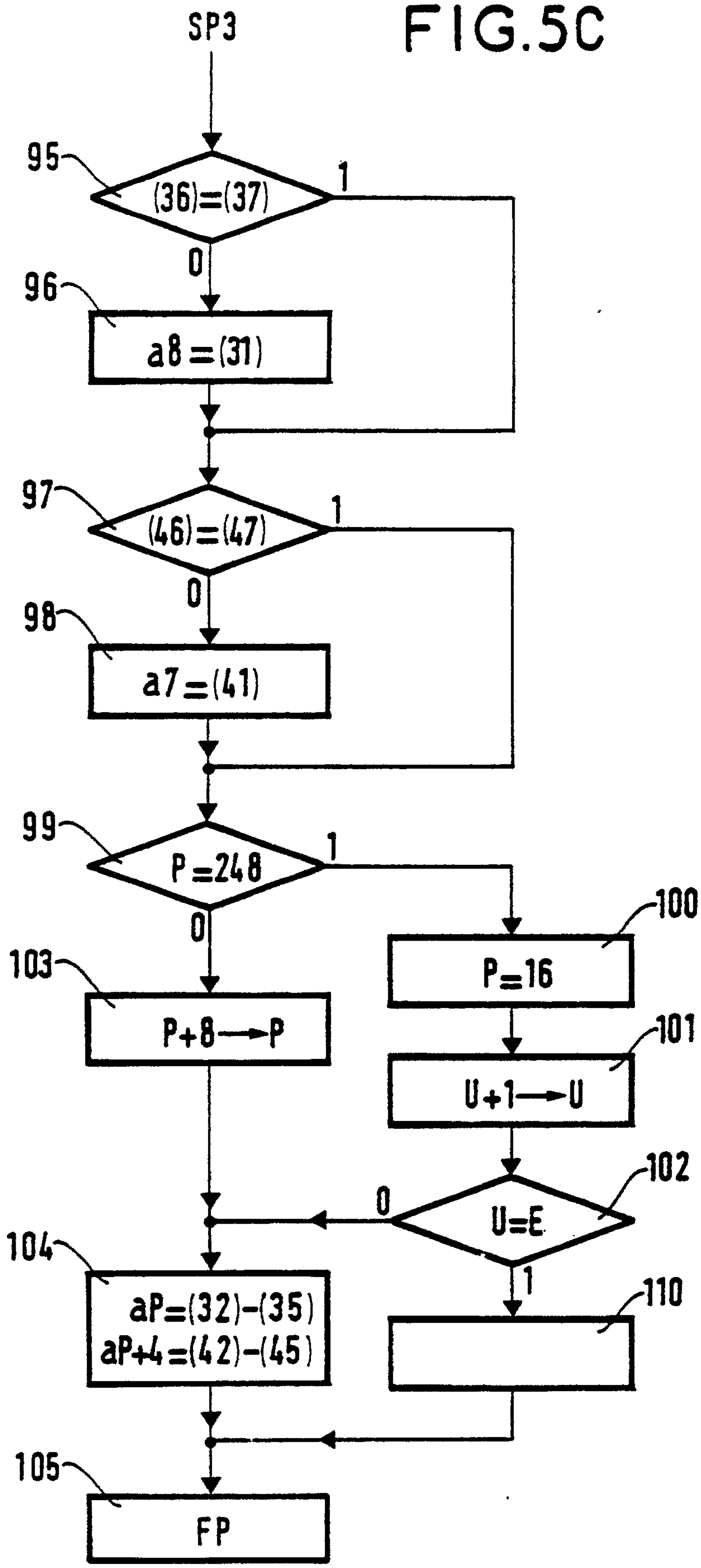
SP3
95
(36)=(37)
1
0
96
a8=(31)
97
(46)=(47)
1
0
98
a7=(41)
99
P=248
1
0
100
P=16
101
U+1→U
102
U=E
0
1
103
P+8→P
104
aP=(32)-(35)
aP+4=(42)-(45)
110
105
FP

FIG.5C